# EUROPEAN PATENT SPECIFICATION

(11) **EP 4 030 619 B1**
(45) Date of publication and mention of the grant of the patent: **07.10.2026**
(21) Application number: 20880574.7
(22) Date of filing: 02.06.2020
(51) Int. Cl.: H03F 1/32, H03F 1/30, H03F 3/195, H03F 3/21, H03F 3/24, H03F 3/68, G06N 3/08, G06N 3/045, G06N 3/09, G06N 3/065

(54) **ELECTRONIC DEVICE FOR PROCESSING INPUT SIGNAL OF POWER AMPLIFIER AND OPERATION METHOD THEREOF**
ELEKTRONISCHE VORRICHTUNG ZUR VERARBEITUNG EINES EINGANGSSIGNALS EINES LEISTUNGSVERSTÄRKERS UND BETRIEBSVERFAHREN DAFÜR
DISPOSITIF ÉLECTRONIQUE POUR LE TRAITEMENT DU SIGNAL D'ENTRÉE D'UN AMPLIFICATEUR DE PUISSANCE ET SON PROCÉDÉ DE FONCTIONNEMENT

(30) Priority: 29.10.2019 KR 20190135603
(43) Date of publication of application: 20.07.2022
(73) Proprietor: Samsung Electronics Co., Ltd., Suwon-si, Gyeonggi-do 16677 (KR); Industry-Academic Cooperation Foundation, Yonsei University, Seoul 03722 (KR)
(72) Inventor: JUNG, Sunghoon, Seoul 07390 (KR); KIM, Jaebum, Suwon-si, Gyeonggi-do 16677 (KR); KU, Jungwoo, Suwon-si, Gyeonggi-do 16677 (KR); WOO, Youngyoon, Suwon-si, Gyeonggi-do 16677 (KR); KIM, Yeonghwan, Seoul 03724 (KR); LEE, Chungyong, Seoul 06608 (KR)
(74) Representative: Gulde & Partner
(86) International application number: PCT/KR2020/007149
(87) International publication number: WO 2021/085780

(56) References cited:
- JP-A- 2005 073 032
- KR-A- 20140 076 143
- KR-A- 20170 110 275
- KR-B1- 101 768 905
- US-A1- 2010 069 023
- US-B2- 9 214 969
- GRACIA SAEZ RAUL ET AL: "RF Power Amplifier Linearization in Professional Mobile Radio Communications Using Artificial Neural Networks", IEEE TRANSACTIONS ON INDUSTRIAL ELECTRONICS, IEEE SERVICE CENTER, PISCATAWAY, NJ, USA, vol. 66, no. 4, 1 April 2019 (2019-04-01), pages 3060 - 3070, XP011703747, ISSN: 0278-0046, [retrieved on 20181203], DOI: 10.1109/TIE.2018.2842780
- NASKAS N ET AL: "An adaptive power amplifier lineariser based on a multilayer perceptron", VTC 2003-SPRING. THE 57TH. IEEE SEMIANNUAL VEHICULAR TECHNOLOGY CONFERENCE. PROCEEDINGS. JEJU, KOREA, APRIL 22 - 25, 2003; [IEEE VEHICULAR TECHNOLGY CONFERENCE], NEW YORK, NY : IEEE, US, vol. 2, 22 April 2003 (2003-04-22), pages 1331 - 1334, XP010862619, ISBN: 978-0-7803-7757-8, DOI: 10.1109/VETECS.2003.1207844
- ZAYANI RAFIK ET AL: "Levenberg-Marquardt learning neural network for adaptive predistortion for time-varying HPA with memory in OFDM systems", 2010 18TH EUROPEAN SIGNAL PROCESSING CONFERENCE, IEEE, 25 August 2008 (2008-08-25), pages 1 - 5, XP032760863, ISSN: 2219-5491, [retrieved on 20150403]
- HESAMI SARA ET AL: "Single Digital Predistortion Technique for Phased Array Linearization", 2019 IEEE INTERNATIONAL SYMPOSIUM ON CIRCUITS AND SYSTEMS (ISCAS), IEEE, 26 May 2019 (2019-05-26), pages 1 - 5, XP033574566, ISSN: 2158-1525, ISBN: 978-1-7281-3320-1, [retrieved on 20190429], DOI: 10.1109/ISCAS.2019.8702811
- HABU SUGURU ET AL: "Unified Feedback Beamforming Digital Predistorter", 2019 14TH EUROPEAN MICROWAVE INTEGRATED CIRCUITS CONFERENCE (EUMIC), EUROPEAN MICROWAVE ASSOCIATION (EUMA), 30 September 2019 (2019-09-30), pages 350 - 353, XP033640755, [retrieved on 20191121], DOI: 10.23919/EUMIC.2019.8909504
- TERVO NUUTTI ET AL: "Digital predistortion of amplitude varying phased array utilising over-the-air combining", 2017 IEEE MTT-S INTERNATIONAL MICROWAVE SYMPOSIUM (IMS), IEEE, 4 June 2017 (2017-06-04), pages 1165 - 1168, XP033159941, [retrieved on 20171004], DOI: 10.1109/MWSYM.2017.8058809
- PAN WENSHENG ET AL: "Digital Linearization of Multiple Power Amplifiers in Phased Arrays for 5G Wireless Communications", 2018 IEEE INTERNATIONAL SYMPOSIUM ON SIGNAL PROCESSING AND INFORMATION TECHNOLOGY (ISSPIT), IEEE, 6 December 2018 (2018-12-06), pages 247 - 251, XP033518656, [retrieved on 20190214], DOI: 10.1109/ISSPIT.2018.8642775

## Description

### TECHNICAL FIELD

The disclosure relates to an electronic device for processing an input signal of an amplifier and a method of operating the electronic device.

### BACKGROUND ART

An amplifier (e.g., power amplifier (PA)) available for wireless communication systems may output signals distorted differently depending on the environment of the amplifier. For example, depending on the temperature around the amplifier, and the intensity and band of an input signal input to the amplifier, a signal output from the amplifier may be distorted differently.

Hence, to prevent distortion of the output signal of the amplifier, a pre-distorter (e.g., digital predistortion (DPD)) may be used to process an input signal based on information about an environment of the amplifier and input the processed input signal to the amplifier. As the input signal to be input to the amplifier is pre-distorted by the pre-distorter, an output signal distorted to the minimum may be output from the amplifier.

Raúl Garcia Sáez, et al. disclose in an academic paper published in April 2019, a RF power amplifier linearization in professional mobile radio communications using artificial neural networks. N. Naskas, et al. disclose in an academic paper published in April 2003, an adaptive power amplifier linearizer based on a multilayer perception. Rafik Zayani, et al. disclose in an academic paper published in August 2008, the Levenberg-Marquardt learning neural network for adaptive predistortion for time-varying HPA with memory in OFDM systems. US9214969B2 discloses a scalable digital predistortion system. Author: Sara Hesami et al: "Single Digital Predistortion Technique for Phased Array Linearization"; Reference: XP 33574566 A, discloses a linearization technique for nonlinear phased array antennas. Author: Suguru Habu et al: " Unified Feedback Beamforming Digital Predistorter"; Reference: XP 33640755 A, where a novel digital predistortion (DPD) architecture for amplitude- and phase- weighted beamforming (BF) transmitter is proposed. Author: Nuutti Tervo et al: "Digital Predistortion of Amplitude Varying Phased Array Utilising Over-the-Air Combining"; Reference: XP 33159941 A, discloses a simple polynomial linearisation technique for nonlinear phased arrays including amplitude control. Author: Wensheng Pan et al: " Digital Linearization of Multiple Power Amplifiers in Phased Arrays for 5G Wireless Communications"; Reference: XP 33518656 A, where digital predistortion (DPD) architecture is proposed to linearize power amplifiers (PAs) in a phased array applicable to the wireless communication systems.

However, an output signal with a different degree of distortion is output from the amplifier each time the environmental information is changed, so coefficients or a neural network model used in the pre-distorter needs to be updated. Hence, there is a problem of having to perform an operation to update the pre-distorter whenever the environmental information is changed.

### DESCRIPTION OF EMBODIMENTS

### TECHNICAL PROBLEM

An objective of the disclosure is to address the aforementioned problem and provide an electronic device for processing an input signal of an amplifier and a method of operating the electronic device.

Another objective of the disclosure is to provide a computer-readable recording medium having a program recorded thereon for a computer to execute the method. Technical objectives of the disclosure are not limited thereto, and there may be other technical objectives.

### BRIEF DESCRIPTION OF DRAWINGS

FIG. 1 is a block diagram illustrating an example of an electronic device including a pre-distorter and an amplifier, according to an embodiment.
FIG. 2 is a block diagram for describing an internal configuration of an electronic device, according to an embodiment.
FIG. 3 is a block diagram for describing an internal configuration of an electronic device, according to another embodiment.
FIG. 4 is a flowchart illustrating a method of processing an input signal of an amplifier, according to an embodiment.
FIG. 5 is a block diagram illustrating an example of a partially-connected hybrid beamforming system, according to an embodiment.
FIG. 6 illustrates an example of a method of training a neural network model of digital pre-distortion (DPD), according to an embodiment.
FIG. 7 illustrates an example of a method of training a neural network model of DPD, according to another embodiment.
FIG. 8 is a block diagram illustrating an example of a fully-connected hybrid beamforming system, according to an embodiment.
FIG. 9 illustrates an example of a method of training a neural network model of DPD, according to another embodiment.
FIG. 10 illustrates an example of a method of training a neural network model of DPD in an indirect learning scheme based on a valid power amplifier (PA), according to an embodiment.
FIG. 11 illustrates an example of a method of training a neural network model of DPD, according to another embodiment.

### MODE OF DISCLOSURE

For achieving the technical objectives, in a first aspect of the disclosure, a method of processing an input signal of a plurality of amplifiers comprised in a hybrid beamforming system includes obtaining an input signal for the plurality of amplifiers; obtaining information about an environment of the plurality of amplifiers; pre-distorting the input signal by using a pre-distorter based on the obtained environmental information to prevent a plurality of output signals in response to the input signal to be processed by each of the plurality of amplifiers from being distorted; and inputting the pre-distorted input signal to each of the plurality of amplifiers, wherein the pre-distorter is configured to pre-distort the input signal of the plurality of amplifiers by using a pretrained neural network model, wherein the pretrained neural network model is pretrained based on signals input to and output from each of the plurality of amplifiers and corresponding environmental information where the plurality of amplifiers operates.

In a second aspect of the disclosure, a hybrid beamforming system for processing an input signal of a plurality of amplifiers includes at least one processor configured to obtain an input signal for the plurality of amplifiers, obtain information about an environment of the plurality of amplifiers, pre-distort the input signal by using a pre-distorter based on the obtained environmental information to prevent a plurality of output signals in response to the input signal to be processed by each of the plurality of amplifiers from being distorted, and input the pre-distorted input signal to each of the plurality of amplifiers; and a communication module configured to wirelessly transmit a signal output from the plurality of amplifiers, wherein the pre-distorter is configured to pre-distort the input signal of the plurality of amplifiers by using a pretrained neural network model, wherein the pretrained neural network model is pretrained in advance based on signals input to and output from each of the plurality of amplifiers and corresponding environmental information where the plurality of amplifiers operates.

According to a third aspect of the disclosure, provided is a recording medium storing a program, which, when executed by a computer, causes the computer to perform to perform the method of at least one of the first aspect or the second aspect.

Embodiments of the disclosure will now be described with reference to accompanying drawings to assist those of ordinary skill in the art in readily implementing them. However, the embodiments of the disclosure may be implemented in many different forms, and are not limited to those discussed herein. In the drawings, parts unrelated to the description are omitted for clarity, and like numerals refer to like elements throughout the specification.

When A is said to "be connected" to B, it means to be "directly connected" to B or "electrically connected" to B with C located between A and C. The term "include (or including)" or "comprise (or comprising)" is inclusive or open-ended and does not exclude additional, unrecited elements or method steps, unless otherwise mentioned.

The disclosure will now be described in detail with reference to accompanying drawings.

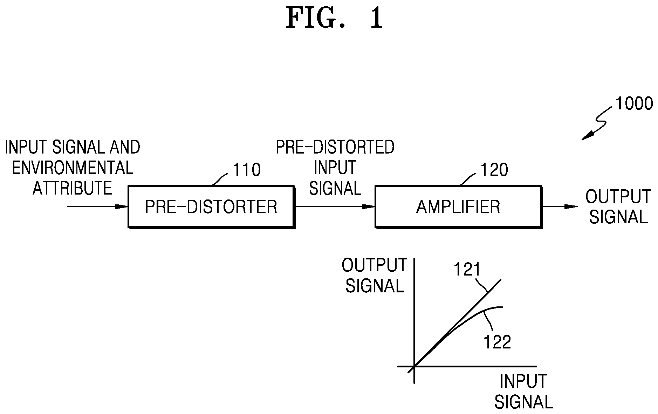

FIG. 1 is a block diagram illustrating an example of an electronic device 1000 including a pre-distorter 110 and an amplifier 120, according to an embodiment.

Referring to FIG. 1, the electronic device 1000 according to an embodiment may include the pre-distorter 110 for processing an input signal of the amplifier 120 and the amplifier 120 for amplifying and outputting the input signal processed by the predistorter 110.

In an embodiment, the amplifier 120 may amplify and output a signal input thereto. In an embodiment, an output signal of the amplifier 120 may be linearly output, as indicated by 121, for the input signal. However, the output signal of the amplifier 120 may be distorted, as indicated by 122, due to environmental conditions (e.g., the temperature, and a size and band of the input signal).

In an embodiment, the pre-distorter 110 may process the input signal of the amplifier 120 so that distortion of the output signal may be minimized, and input a result of the processing to the amplifier 120. For example, the pre-distorter 110 may pre-distort the input signal of the amplifier 120. In an embodiment, an output signal for the input signal pre-distorted by the pre-distorter 110 may be output linearly, as indicated by 121.

In an embodiment, the pre-distorter 110 may process the input signal by using a pretrained neural network model. The neural network model used in the pre-distorter 110 may be a model trained in advance based on a plurality of pieces of environmental information available for the amplifier 120.

In an embodiment, the neural network model available for the pre-distorter 110 may be a data recognition model based on a neural network such as e.g., a deep neural network (DNN), a recurrent neural network (RNN), etc. It is not limited thereto, and various types of neural network models may be used in the pre-distorter 110.

In an embodiment, the pre-distorter 110 may pre-distort the input signal by inputting information about an environment of the amplifier 120 that corresponds to a cause of distortion of an output signal to the pretrained neural network model along with the input signal. Accordingly, the pre-distorter 110 in an embodiment may process the input signal based on the information about the environment of the amplifier 120 and input a result of the processing to the amplifier 120.

In an embodiment, the pre-distorter 110 and the amplifier 120 may be included in a wireless communication system and used in wireless transmission of at least one input stream.

In an embodiment, a neural network model of the pre-distorter 110 may be trained in advance based on training data including input and output signals of the amplifier 120 operating in a plurality of different environments and environmental information corresponding to the different environments. In an embodiment, the training data may be obtained from the input and output signals of the amplifier 120 that are experimentally obtained according to operations of the hardware configuration provided to include the amplifier 120, for training the neural network model.

In an embodiment, the neural network model of the pre-distorter 110 may be trained based on training data including a plurality of sets of input and output signals of the amplifier 120 experimentally obtained in different environments and information about environments of the amplifier 120 corresponding to the input and output signals of the amplifier 120. For example, each time the environment of the amplifier 120 changes, the training data may be obtained to include a set of input and output signals obtained through an experiment in the changed environment and changed environmental information of the amplifier 120. Accordingly, the training data may include a plurality of sets of input and output signals corresponding to different environments and the environmental information of the amplifier 120.

In an embodiment, the amplifier 120 may be an amplification unit that processes at least one input signal and outputs at least one output signal. In an embodiment, the amplification unit may include at least one amplifier 120 to output at least one output signal as a result of processing the at least one input signal.

In an embodiment, the amplification unit may further include various kinds of components in addition to the at least one amplifier 120. For example, the amplification unit may further include other components such as an antenna, an analog beamformer, etc., required to wirelessly transmit a signal processed by the amplifier 120.

In an embodiment, a neural network model of the pre-distorter 110 may be trained in advance to pre-distort an input signal not only with respect to the amplifier 120 for amplifying signals but also to the signal processor (not shown) that processes the signal in various methods. In an embodiment, the neural network model of the predistorter 110 may pre-distort the input signal to prevent distortion of an output signal of a signal processor (not shown). In an embodiment, the pre-distorter 110 may be operated according to the neural network model trained based on training data including a set of input and output signals of the signal processor (not shown) that operates in a plurality of different environments and environmental information corresponding to the different environments.

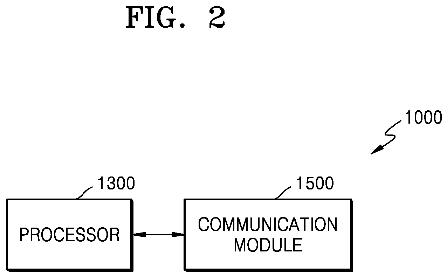

FIG. 2 is a block diagram for describing an internal configuration of the electronic device 1000, according to an embodiment.

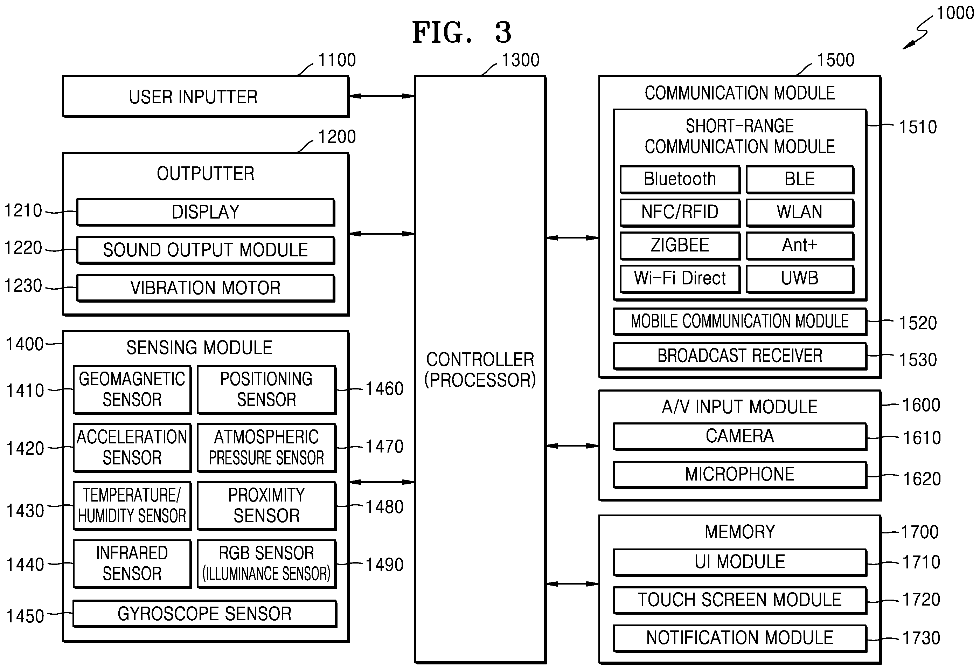

FIG. 3 is a block diagram for describing an internal configuration of the electronic device 1000, according to another embodiment.

Referring to FIG. 2, the electronic device 1000 may include a processor 1300 and a communication module 1500. All components shown in FIG. 2 are not, however, essential components for the electronic device 1000. The electronic device 1000 may be implemented with more or fewer components than in FIG. 2.

For example, as shown in FIG. 3, the electronic device 1000 may further include a user input module 1100, an output module 1200, a sensing module 1400, an audio/video (A/V) input module 1600, and a memory 1700 in addition to the processor 1300 and the communication module 1500.

The user input module 1100 refers to a means that allows the user to enter data to control the electronic device 1000. For example, the user input module 1100 may include a key pad, a dome switch, a (capacitive, resistive, infrared detection type, surface acoustic wave type, integral strain gauge type, piezoelectric effect type, and so on) touch pad, a jog wheel, a jog switch, etc., without being limited thereto.

In an embodiment, the user input module 1100 may receive a user input for processing the input signal of the amplifier and outputting the processed input signal through the amplifier.

The output module 1200 may output an audio signal, a video signal, or a vibration signal, and the output module 1200 may include a display 1210, a sound output module 1220, and a vibration motor 1230.

The display 1210 displays information processed in the electronic device 1000. In an embodiment, the display 1210 may output information based on a result of outputting the pre-distorted input signal through the amplifier.

In a case that the display 1210 and a touch pad are implemented in a layered structure to constitute a touch screen, the display 1210 may also be used as an input device apart from the output device. The display 1210 may include at least one of a liquid crystal display (LCD), a thin film transistor-liquid crystal display (TFT-LCD), organic light-emitting diodes (OLEDs), a flexible display, a three-dimensional (3D) display, or an electrophoretic display. Furthermore, depending on a form of implementation of the electronic device 1000, the electronic device 1000 may include two or more displays 1210.

The sound output module 1220 outputs audio data received from the communication module 1500 or stored in the memory 1700. The vibration motor 1230 may output a vibration signal. The vibration motor 1230 may also output a vibration signal when a touch is made on the touch screen. In an embodiment, the sound output module 1220 and the vibration motor 1230 may output information based on a result of outputting the pre-distorted input signal through the amplifier.

The processor 1300 commonly controls general operation of the electronic device 1000. For example, the processor 1300 may execute programs stored in the memory 1700 to generally control the user input module 1100, the output module 1200, the sensing module 1400, the communication module 1500, and the A/V input module 1600.

The electronic device 1000 may include at least one processor 1300. For example, the electronic device 1000 may include various types of processors such as a central processing unit (CPU), a graphics processing unit (GPU), a neural processing unit (NPU), etc.

The processor 1300 may be configured to process instructions of a computer program by performing basic arithmetic, logical, and input/output operations. The instructions may be provided from the memory 1700 to the processor 1300 or received through the communication module 1500 and provided to the processor 1300. For example, the processor 1300 may be configured to execute the instructions according to program codes stored in a recording device such as a memory.

In an embodiment, the processor 1300 may pre-distort the input signal of the amplifier 120 by using the pre-distorter 110 based on the environmental information. In an embodiment, the pre-distorter 110 may pre-distort the input signal by using a pretrained neural network model.

The pretrained neural network model of the pre-distorter 110 in an embodiment may be a neural network model trained in advance to pre-distort the input signal of the amplifier 120 based on signals input to and output from the amplifier 120 obtained while the amplifier 120 is operated in the plurality of different environments and a plurality of pieces of environmental information corresponding to the different environments.

In an embodiment, as the input signal pre-distorted by the pre-distorter 110 is input to the amplifier 120, the amplifier 120 may output an output signal that is distorted to the minimum.

The sensing module 1400 may detect a condition of or around the electronic device 1000 and forward the detected information to the processor 1300.

The sensing module 1400 may include at least one of a geomagnetic sensor 1410, an acceleration sensor 1420, a temperature/humidity sensor 1430, an infrared sensor 1440, a gyroscope sensor 1450, a positioning sensor (e.g., a global positioning system (GPS)) 1460, an air pressure sensor 1470, a proximity sensor 1480, or an RGB sensor (illuminance sensor) 1490, without being limited thereto.

In an embodiment, the sensing module 1400 may be used to obtain information about an environment of the amplifier 120. For example, based on information about the temperature detected by the temperature/humidity sensor 1430, temperature information of the environmental information of the amplifier 120 may be obtained.

The communication module 1500 may include at least one component that allows the electronic device 1000 to communicate with a server 2000 or an external device (not shown). For example, the communication module 1500 may include a short-range communication module 1510, a mobile communication module 1520, and a broadcast receiver 1530.

The short-range communication module 1510 may include a Bluetooth communication module, a Bluetooth low energy (BLE) communication module, a near field communication (NFC) module, a wireless local area network (WLAN), e.g., Wi-Fi, communication module, a Zigbee communication module, an infrared data association (IrDA) communication module, a Wi-Fi direct (WFD) communication module, an ultrawideband (UWB) communication module, an Ant+ communication module, etc., without being limited thereto.

The mobile communication module 1520 transmits or receives wireless signals to and from at least one of a base station, an external terminal, or a server in a mobile communication network. The RF signal may include a voice call signal, a video call signal or different types of data involved in transmission/reception of a text/multimedia message.

The broadcast receiver 1530 receives broadcast signals and/or broadcastingrelated information from the outside on a broadcasting channel. The broadcasting channel may include a satellite channel or a terrestrial channel. Depending on the implementation, the electronic device 1000 may not include the broadcast receiver 1530.

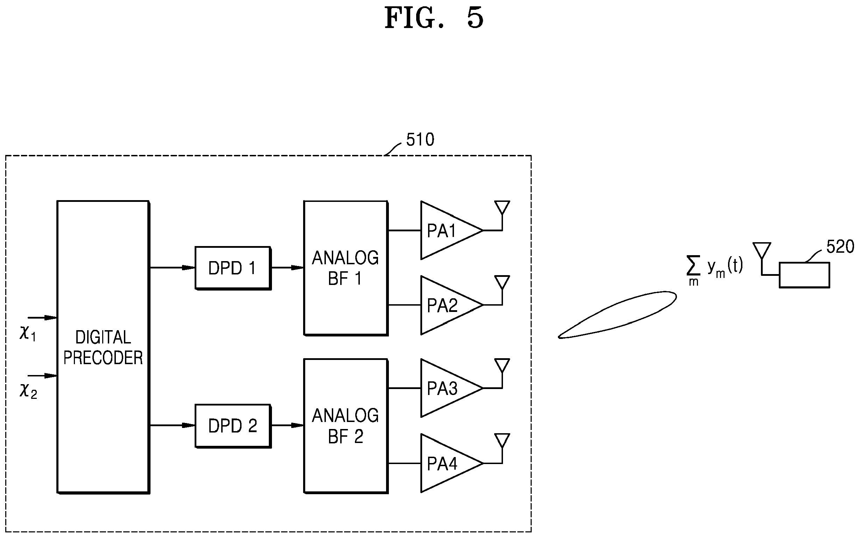

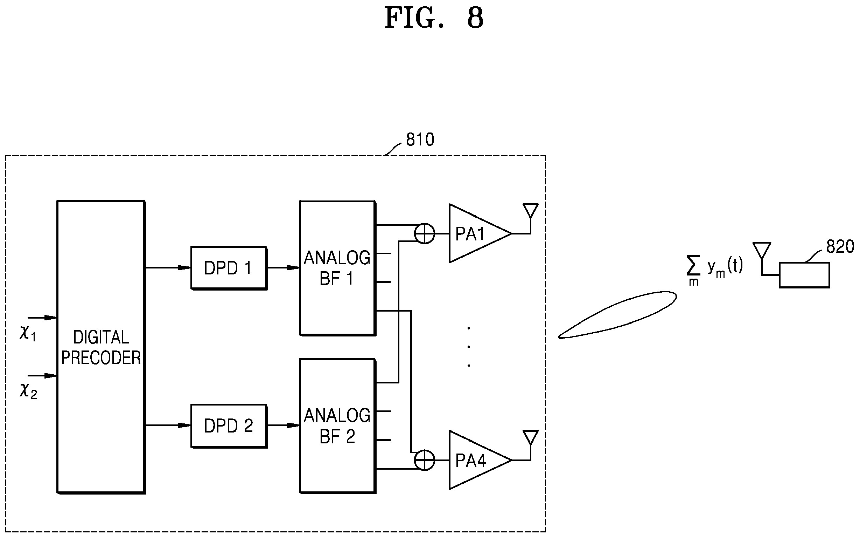

In an embodiment, the communication module 1500 may wirelessly transmit data corresponding to an input signal input to the pre-distorter 110 to a receiver (520 of FIG. 5 or 820 of FIG. 8) based on the signal output from the amplifier 120.

The A/V input module 1600 for inputting audio or video signals may include a camera 1610, a microphone 1620, etc. The camera 1610 may acquire image frames, such as still images or video through an image sensor in a video call mode or a photography mode. An image captured by the image sensor may be processed by the processor 1300 or an extra image processor (not shown). The microphone 1620 may process a sound signal received from the outside into electric voice data.

In an embodiment, based on an audio signal or video signal input by the A/V input module 1600, information about an environment of the amplifier 120 may be obtained. For example, temperature information of the amplifier 120 may be estimated based on the information about the environment of the amplifier 120 based on the video signal input.

The memory 1700 may store a program for processing and control of the processor 1300, or store data input to or output from the electronic device 1000.

In an embodiment of the disclosure, the memory 1700 may store a neural network model to be used in the pre-distorter 110. The neural network model may be a model trained in advance based on information about a plurality of environments available for the amplifier 120.

The memory 1700 may include at least one type of storage medium including a flash memory, a hard disk, a multimedia card micro type memory, a card type memory (e.g., SD or XD memory), a Random Access Memory (RAM), a Static Random Access Memory (SRAM), a Read-Only Memory (ROM), an Electrically Erasable Programmable Read-Only Memory (EEPROM), a Programmable Read-Only Memory (PROM), a magnetic memory, a magnetic disk, and an optical disk.

Programs stored in the memory 1700 may be classified into a plurality of modules according to the functions, e.g., a user interface (UI) module 1710, a touch screen module 1720, a notification module 1730, etc.

The UI module 1710 may provide a specified UI, a graphical user interface (GUI), etc., working with the electronic device 1000 for each application. The touch screen module 1720 may detect a touch gesture of a user over the touch screen and forward information about the touch gesture to the processor 1300. In some embodiments of the disclosure, the touch screen module 1720 may recognize and analyze a touch code. The touch screen module 1720 may include extra hardware including a controller.

Various sensors may be equipped inside or around the touch screen to detect touches or proximity touches. As an example of the sensor to detect touches on the touch screen, there may be a tactile sensor. The tactile sensor refers to a sensor that detects a contact of a particular object to the same extent as or higher than felt by a human. The tactile sensor may detect various metrics such as roughness on a contact surface, hardness of a contacting object, the temperature on a contact point, etc.

The touch gesture of the user may include tapping, touching and holding, double tapping, dragging, panning, flicking, dragging and dropping, swiping, etc.

The notification module 1730 may generate a signal to inform occurrence of an event of the electronic device 1000.

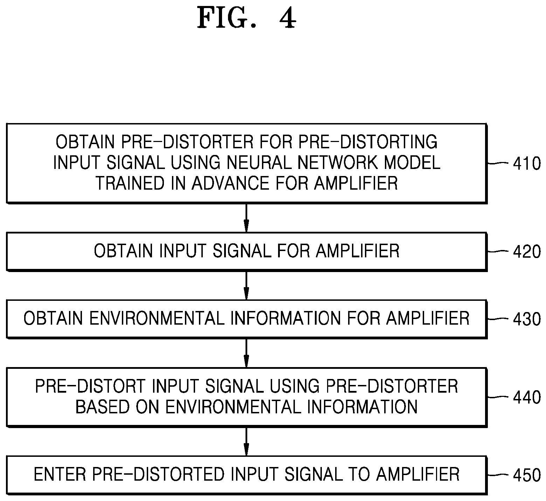

FIG. 4 is a flowchart illustrating a method of processing an input signal of the amplifier 120, according to an embodiment of the disclosure.

Referring to FIG. 4, in operation 410, the electronic device 1000 may obtain the pre-distorter 110 that pre-distorts an input signal by using a pretrained neural network model for the amplifier 120.

The pretrained neural network model of the pre-distorter 110 in an embodiment may be a neural network model trained in advance to pre-distort the input signal of the amplifier 120 based on signals input to and output from the amplifier 120 obtained while the amplifier 120 is operated in the plurality of different environments and a plurality of pieces of environmental information corresponding to the different environments.

In an embodiment, the pretrained neural network model of the pre-distorter 110 may be trained based on training data including input and output signals of the amplifier 120 obtained in a plurality of different environments and environmental information.

The environmental information in an embodiment may include information about, for example, temperature of the amplifier 120, and the magnitude, power and band of a signal input to the amplifier 120 as information about the environment of the amplifier 120. It is not limited thereto, and the environmental information of the amplifier 120 may include various kinds of information that may affect the operation of the amplifier 120 for processing the input signal.

In operations 420 and 430, the electronic device 1000 may obtain an input signal to be input to the amplifier 120 and the environmental information of the amplifier 120.

In an embodiment, the input signal of the amplifier 120 may be a signal including data to be transmitted to an external device (not shown). In an embodiment, the input signal may be amplified by the amplifier 120 and then transmitted to the external device (not shown).

The environmental information of the amplifier 120 in an embodiment may include information about a current environment of the amplifier 120.

Among the information included in the plurality of pieces of environmental information used to train the neural network model in an embodiment, there may be no information clearly matching the environmental information of the amplifier 120. In a case that a look-up table is used for operations of the amplifier 120 corresponding to the plurality of pieces of environmental information, there is a problem in that a resultant value may not be derived because there is no information clearly matching the environmental information of the amplifier 120 in the look-up table.

However, with the neural network model trained based on the plurality of pieces of environmental information in an embodiment, even new input information that has not been used for training may be processed by the neural network model, so a resultant value may be derived even when environmental information that has not been used for training is input to the neural network model.

In operation 440, the electronic device 1000 may perform pre-distortion on the input signal by using the pre-distorter obtained in operation 410 based on the environmental information obtained in operation 430. In an embodiment, the predistorter may input the environmental information and the input signal of the amplifier 120 to the pretrained neural network model to pre-distort the input signal, to output the pre-distorted input signal to the amplifier 120.

In operation 450, the electronic device 1000 may enter the input signal pre-distorted in operation 440 to the amplifier 120. Accordingly, in an embodiment, the input signal of the amplifier 120 may be pre-distorted by the pre-distorter 110 and then input to the amplifier 120, so that distortion of an output signal from the amplifier 120 may be minimized.

Furthermore, in an embodiment, the pre-distorter 110 may pre-distort the input signal by using the pretrained neural network model based on the operation result of the amplifier 120 in a plurality of different environments and the environmental information, without an operation to retrain the neural network model each time the environmental condition changes.

FIG. 5 is a block diagram illustrating an example of a partially-connected hybrid beamforming system, according to an embodiment.

A hybrid beamforming system in an embodiment is a wireless communication system that performs transmission after sequentially performing digital beamforming and analog beamforming on an input stream.

The hybrid beamforming system for performing wireless communication in an embodiment may include a partially-connected hybrid beamforming system and a fully-connected hybrid beamforming system.

The partially-connected hybrid beamforming system in an embodiment may process one input stream with a plurality of amplifiers and output a result of the processing.

In an embodiment, the electronic device 1000 may include the pre-distorter that uses a pretrained neural network model in an embodiment, and may be operated according to the partially-connected hybrid beamforming system as shown in FIG. 5. For example, in the partially-connected hybrid beamforming system, the electronic device 1000 may be a transmitter 510 for wirelessly transmitting data, and digital pre-distorters DPD 1 and DPD 2, which are pre-distorters included in the transmitter 510 may operate according to a pretrained neural network model in an embodiment.

Referring to FIG. 5, the partially-connected hybrid beamforming system, which is a wireless communication system, may include the transmitter 510 and the receiver 520. In an embodiment, the transmitter 510 may include a digital precoder, a pre-distorter (e.g., a DPD), an analog beamformer (BF), and an amplifier (e.g., a power amplifier (PA)).

In an embodiment, streams χ₁ and χ₂ to be transmitted to the receiver 520 from the transmitter 510 may be subjected to digital beamforming by the digital precoder and may then be input to DPD 1 and DPD 2, respectively. The streams entered to and pre-distorted by DPD1 and DPD 2 may be phase-shifted by analog BFs 1 and 2, amplified by a plurality of PAs, and wirelessly transmitted to the receiver 520 through antennas.

For example, when the stream χ₁ (t) entered to the digital precoder is amplified by m amplifiers (e.g., PA 1 and PA 2) and wirelessly transmitted, χ₁ (t) may be obtained from a sum ${\sum }_{m} {y}_{m} \left(t\right)$ of signals received by the receiver 520. In an embodiment, a neural network model of each DPD may be trained to minimize a difference between ${\sum }_{m} {y}_{m} \left(t\right)$ and χ₁ (t).

The analog BF1 in an embodiment may send a plurality of signals obtained by differently adjusting the phase of the digital beamformed stream χ₁ to the PA 1 and PA 2. In an embodiment, the digitally beamformed stream χ₁ may be processed by DPD 1, the analog BF1, and the amplification unit including the PA 1 and PA 2, such that a sum of signals received by the receiver 520, which is a sum of signals amplified by the PA 1 and PA 2 and output through the antennas, is equal to the stream χ₁.

Neural network models of the DPD 1 and DPD 2 in an embodiment may be pretrained based on information obtained according to the operation of the amplification unit including the PA 1 and PA 2 or the amplification unit including PA 3 and PA 4 in a plurality of different environments.

In an embodiment, there may be a neural network model of the DPD corresponding to each input stream. For example, a neural network model of the DPD 1 that processes the stream χ₁ may be trained based on training data obtained based on the operation of the amplification unit including the PA 1 and PA 2 to process the stream χ₁. Likewise, a neural network model of the DPD 2 to process the stream χ₂ may be trained based on training data obtained based on the operation of the amplification unit including the PA 3 and PA 4 to process the stream χ₂.

For example, the neural network model of the DPD 1 may be pretrained based on input and output signals of the amplification unit including the PA 1 and PA 2 obtained according to the operation of the amplification unit in a plurality of different environments and a plurality of pieces of environmental information corresponding to the different environments. Also, the neural network model of the DPD 2 may be pretrained based on input and output signals of the amplification unit including the PA 3 and PA 4 obtained according to the operation of the amplification unit in a plurality of different environments and a plurality of pieces of environmental information corresponding to the different environments.

In an embodiment, the amplification unit may further include configuration of an analog BF 1 and an antenna or an analog BF 2 and an antenna, connected to the PA 1 and PA 2 or the PA 3 and PA 4 and used for wireless transmission to the receiver 520. Accordingly, the signals entered to and output from the amplification unit to be used to pretrain the neural network model may be signals entered to the analog BF1 (or analog BF2) and signals output through the antenna.

In an embodiment, for the neural network model of the DPD 1 or DPD2, training data may be obtained based on the operation of the amplification unit of the transmitter 510 performed in different environments, and based on the training data, the neural network model may be trained. The neural network model of the DPD 1 or DPD 2, for which training is completed, may be used for the DPD 1 or DPD 2 in the transmitter 510.

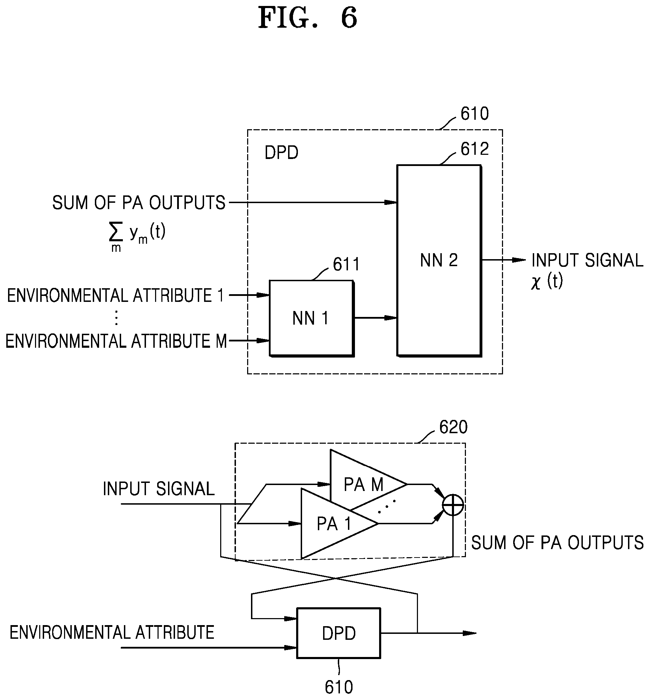

FIG. 6 illustrates an example of a method of training a neural network model of a DPD based on an indirect learning scheme, according to an embodiment of the disclosure.

In an embodiment, for training of the neural network model 610, hardware configuration corresponding to an amplification unit 620 may be provided. In an embodiment, the amplification unit 620 may include at least one PA to process at least one input signal and output at least one output signal.

In an embodiment, based on input and output signals of the amplification unit 620 that operates in different environments, training data for training the neural network model 610 may be obtained experimentally.

In an embodiment, for training the neural network model 610, the environment of the amplification unit 620 may be artificially adjusted, and training data may be obtained based on an operation result of the amplification unit 620 each time the environment is adjusted. Accordingly, the training data in an embodiment may include a plurality of sets of input and output signals of the amplification unit 620 obtained in a plurality of different environments and the environmental information.

In an embodiment, after the training data is obtained in the plurality of different environments, the neural network model 610 of the DPD may be trained based on the training data.

According to an indirect learning scheme in an embodiment, the neural network model 610 of the DPD may be trained based on training data including a plurality of sets of at least one input signal entered to the amplification unit 620 obtained in a plurality of different environments and at least one output signal of the amplification unit 620 in response to the at least one input signal, and environmental information corresponding to the different environments.

Furthermore, in an embodiment, the neural network model 610 may be trained based on the training data such that at least one input signal included in the training data is output from the neural network model 610 when at least one output signal and environmental information included in the training data are entered to the neural network model 610.

In an embodiment, the indirect learning scheme is used to train the neural network model 610 to minimize a difference between the input signal entered to the DPD and the output signal of the amplification unit 620. In an embodiment, an output signal of the amplification unit 620 is a signal to be wirelessly transmitted through the antenna, which may correspond to a signal received by the receiver 520 and may be equal to the input signal entered to the DPD.

Accordingly, the neural network model 610 may be trained on the assumption that the input signal entered to the DPD and the output signal of the amplification unit 620 are the same. According to an embodiment, the indirect learning scheme may be used such that an input signal of the DPD goes through the DPD and is entered to the amplification unit 620, from which an output signal is output. The input signal of the amplification unit 620 may be seen as an output signal of the DPD, so in an embodiment, the neural network model 610 of the DPD may be trained by assuming that the output signal of the amplification unit 620 assumed to be equal to the input signal to the DPD goes through the DPD and is output as the input signal of the amplification unit 620.

According to the indirect learning scheme in an embodiment, as the neural network model 610 is trained to output an input signal of the amplification unit 620 when an output signal of the amplification unit 620 is entered, the input and output signals being different from the input and output of the DPD that may be actually operated in the electronic device 1000, there may be a small error.

However, in an embodiment, even with the existence of the small error, the neural network model 610 trained according to the indirect learning scheme may significantly remove distortion of the signal output from the amplification unit 620.

According to the partially-connected hybrid beamforming system as shown in FIG. 5, a signal pre-distorted by the DPD may be entered to the amplification unit 620 including a plurality of PAs, which may, in turn, output a plurality of signals.

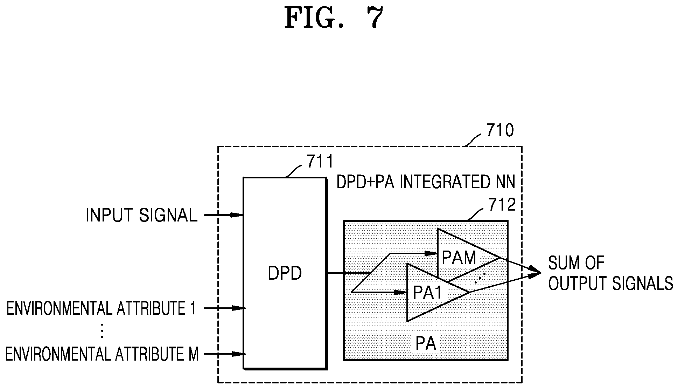

In the electronic device 1000 in an embodiment, when one signal pre-distorted by the DPD is entered to the amplification unit 620 including the plurality of PAs and a plurality of signals are output from the plurality of PAs as in the partially-connected hybrid beamforming system, the neural network model 610 of the DPD included in the electronic device 1000 may be trained according to the indirect learning scheme as shown in FIG. 6 or a direct learning scheme as shown in FIG. 7, which will be described later.

In an embodiment, the neural network model 610 of the DPD may be trained such that an input signal entered to the plurality of PAs is output when a representative value of output values of the plurality of PAs that amplify the same input signal, and environmental information of the plurality of PAs are entered thereto.

In an embodiment, an input signal entered to the amplification unit 620 may be adjusted to have different phases, which are entered to the plurality of PAs included in the amplification unit 620, respectively, so that a plurality of output signals may be output from the plurality of PAs.

The representative value of the output signals in an embodiment may be determined to be a sum of the plurality of output signals output from the plurality of PAs. In an embodiment, when the amplification unit 620 further includes a configuration of an antenna in addition to the amplifier, the sum of the plurality of output signals may be determined as a sum of a plurality of output signals output through the antenna to be wirelessly transmitted.

The neural network model 610 of the DPD in an embodiment may include a neural network (NN) 1 611 and an NN 2 612. The NN 1 611 may include a neural network model to obtain a representative value of a plurality of environmental attributes included in environmental information of the amplification unit 620. A neural network model of the NN 2 612 may be trained to output an input signal of the PA based on the representative value of the environmental attributes obtained by the NN 1 611 and a sum of PA output signals.

It is not limited thereto, and the neural network model 610 of the DPD may be a single neural network model trained to output the input signal entered to the plurality of PAs when a sum of output signals for the plurality of PAs and the plurality of environmental attributes are entered thereto, without a neural network model for obtaining the representative value of the plurality of environmental attributes.

The environmental attribute entered to train the neural network model 610 of the DPD in an embodiment may be a value that represents information about the environment of the plurality of PAs corresponding to a pair of the sum of output signals for the plurality of PAs and the input signal entered to the plurality of PAs.

In an embodiment, when the DPD and the plurality of PAs are operated, a plurality of environmental attributes about temperature of the plurality of PAs, a magnitude and a band of the input signal may be obtained. Furthermore, through operation of the device including the DPD and the plurality of PAs in an environment corresponding to the plurality of environmental attributes obtained, a pair of the sum of output signals of the plurality of PAs and the input signal entered to the PA may be obtained. In an embodiment, the neural network model 610 of the DPD may be trained based on training data including the plurality of environmental attributes, a sum of output signals of the plurality of PAs, and the input signal, which are obtained experimentally.

In an embodiment, as the environment of the plurality of PAs variously change, the environmental attributes obtained in the varying environment may be used to train the neural network model 610 of the DPD. Accordingly, in an embodiment, training data for training the neural network model 610 of the DPD may be obtained based on the environmental attributes obtained in a changed environment and input and output signals of the plurality of PAs operating in the changed environment.

Hence, in an embodiment, the neural network model 610 of the DPD may be trained based on training data including a set of a sum of output signals of the plurality of PAs, an input signal, and environmental information including the environmental attributes, which are obtained through operation of the device including the DPD and the plurality of PAs in different environments having different environmental attributes.

FIG. 7 illustrates an example of a method of training a neural network model of a DPD based on a direct learning scheme, according to another embodiment.

According to a direct learning scheme in an embodiment, a neural network model 711 may be trained based on training data including a plurality of pairs of learning models existing in different environments in which operations of the amplification unit are modeled, and environmental information corresponding to the different environments, which are obtained according to the operation of the amplification unit performed in the different environments. In an embodiment, the amplification unit may include at least one PA to process at least one input signal and output at least one output signal.

A learning model in which operation of the amplification unit is modeled in an embodiment may be obtained as training data based on input and output signals of the amplification unit including at least one PA, which operates differently depending on the environment. For example, the learning model may be modeled such that an output signal experimentally observed in response to an arbitrary input signal of the amplification unit may be output as an output signal of the learning model.

Furthermore, in an embodiment, when at least one input signal and environmental information of the training data are processed and output by a neural network model 711 and the modeled learning model of the training data in sequence, the neural network model 711 may be trained such that the at least one input signal entered to the neural network model 711 is equal to at least one output signal of the modeled learning model.

When the neural network model 711 is trained according to an embodiment, the at least one input signal entered to the neural network model 711 may be an arbitrary input signal to train the neural network model 711.

According to the direct learning scheme in an embodiment, because, unlike the indirect learning scheme, signals entered to and output from the neural network model 711 of the DPD are not different from signals entered to and output from the DPD actually operating in the electronic device 1000 when the neural network model 711 is trained, a smaller error than in the indirect learning scheme may occur.

According to the partially-connected hybrid beamforming system as shown in FIG. 5, a signal pre-distorted by the DPD may be entered to the amplification unit 620 including a plurality of PAs, which may, in turn, output a plurality of signals.

In the electronic device 1000 in an embodiment, when one signal pre-distorted by the DPD is entered to the amplification unit including the plurality of PAs and a plurality of signals are output from the plurality of PAs as in the partially-connected hybrid beamforming system, the neural network model 711 of the DPD included in the electronic device 1000 may be trained according to the direct learning scheme of FIG. 7 as well as the indirect learning scheme as shown in FIG. 7.

In an embodiment, for training of the neural network model 711, hardware configuration corresponding to the amplification unit may be provided.

In an embodiment, after the training data is obtained in the plurality of different environments, the neural network model 711 of the DPD may be trained based on the training data. The training data in an embodiment may include a plurality of pairs of environmental information corresponding to different environments and a learning model in which operation of the amplification unit corresponding to the different environments is modeled, which is obtained according to the operation of the amplification unit performed in the different environments.

In an embodiment, the neural network model 711 of the DPD may be trained such that a representative value of a plurality of output signals of the modeled learning model is equal to the input signal entered to the plurality of PAs.

The learning model 712 in which operation of the amplification unit including the plurality of PAs is modeled is one in which operations of at least one of the analog BF that differently adjusts the phase of the pre-distorted input signal and outputs them to the plurality of PAs and the antenna that wirelessly transmits the amplified signals are modeled altogether.

The learning model 712 in which operation of the amplification unit including the plurality of PAs is modeled in an embodiment may be built by being trained in advance based on the operation of the PA of the device provided for obtaining the training data and may then be used to train the neural network model 711 of the DPD. For example, in an environment corresponding to a plurality of environmental attributes, a sum of signals output through the plurality of PAs in response to various input signals may be obtained. The learning model 712 in which operations of the plurality of PAs are modeled in an embodiment may be modeled to output a sum of the output signals obtained in response to the various input signals in an environment corresponding to a plurality of environmental attributes.

When the neural network model 711 of the DPD is trained in an embodiment, data of the learning model 712 in which operations of the plurality of PAs are modeled may be fixed without modification.

FIG. 8 is a block diagram illustrating an example of a fully-connected hybrid beamforming system, according to an embodiment.

Referring to FIG. 8, in the fully-connected hybrid beamforming system, a plurality of input streams may be processed and output by a plurality of amplifiers.

In the fully-connected hybrid beamforming system in an embodiment, a sum of the plurality of input streams may be processed and output by each of the plurality of amplifiers. For example, each amplifier in the fully-connected hybrid beamforming system may receive a sum of a plurality of input streams that are phase-shifted by an analog beamformer. In an embodiment, each of the plurality of PAs of the fully-connected hybrid beamforming system may amplify a sum of the plurality of streams that have been subjected to analog beamforming.

Accordingly, unlike the partially-connected hybrid beamforming system, a plurality of input streams may be entered to and processed by each amplifier in the fully-connected hybrid beamforming system.

In an embodiment, the fully-connected hybrid beamforming is a wireless communication system, which may include a digital precoder, a pre-distorter (e.g., a DPD), an analog beamformer, and an amplifier (e.g., a power amplifier (PA)).

In the fully-connected hybrid beamforming system in an embodiment, as in the partially-connected hybrid beamforming system, input streams χ₁ and χ₂ pre-distorted by the DPD may be amplified by a plurality of PAs and wirelessly transmitted to the receiver 520 through an antenna.

In an embodiment, when the stream χ₁ (t) entered to the digital precoder is amplified and wirelessly transmitted by m amplifiers, χ₁ (t) may be obtained from a sum of signals received by the receiver 520 ${\sum }_{m} {y}_{m} \left(t\right)$.

In an embodiment, for the neural network model of DPD 1 and DPD 2, unlike the partially-connected hybrid beamforming, a neural network model trained with one DPD into which the DPD 1 and DPD 2 are integrated may be used.

In the fully-connected hybrid beamforming system in an embodiment, the input signal may be pre-distorted based on the neural network model of the DPD trained according to an embodiment. In the fully-connected hybrid beamforming system in an embodiment, rather a sum of the plurality of input streams than one input stream as in the partially-connected hybrid beamforming system may be entered to and wirelessly transmitted by a PA. Hence, it is difficult to obtain a pre-distorted input stream based on environmental information because the mathematical formula to pre-distort the input stream is not linear or is complicated.

However, in an embodiment, even in the fully-connected hybrid beamforming system, a neural network model pretrained in the fully-connected hybrid beamforming system may be used to enter the pre-distorted input stream to each PA based on the environmental information for the PA.

In an embodiment, N streams to be transmitted to the receiver 820 from a transmitter 810 may be subjected to digital beamforming in the digital precoder and may then be entered to the neural network model of the integrated DPD. The streams entered to and pre-distorted by the DPD may be phase-shifted by the N analog BFs, amplified and wirelessly transmitted by M PAs to the receiver 820.

In an embodiment, the DPD may pre-distort the input signal of the PA to minimize distortion of a signal to be output by the PA, so that a difference between the stream received at the receiver 820 and the steam to be transmitted from the transmitter 810 may be minimized.

In an embodiment, the N streams may be pre-distorted by the DPD and amplified by the M amplifiers. The signals obtained by amplifying the N streams with the M amplifiers may be wirelessly transmitted to the receiver 820 through the antennas. The receiver 820 may obtain N streams through an antenna.

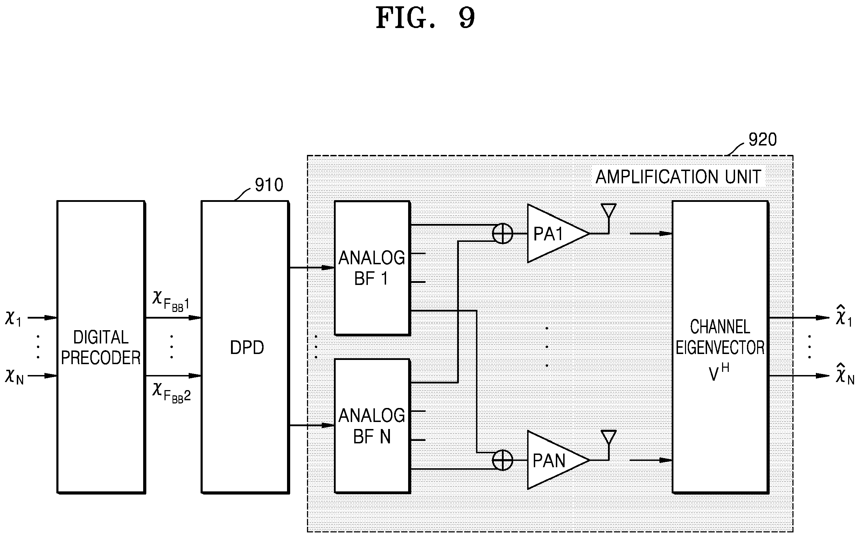

FIG. 9 illustrates an example of a method of training a neural network model of DPD, according to another embodiment.

In an embodiment, for training of the neural network model 910 of the DPD, hardware configuration corresponding to an amplification unit 920 may be provided. An amplification unit 920 in an embodiment may be defined as a valid PA, which includes M PAs to process N input signals and output N output signals. For example, a configuration of N analog BFs for receiving the N output signals of the neural network model 910 of the DPD, M PAs, and a channel eigenvector that outputs N signals so that N wirelessly transmitted signals are observed in the receiver 820 may be defined as a virtual valid PA. In an embodiment, N output signals of the amplification unit 920 may be signals wirelessly transmitted through M amplifiers as the signals observed in the receiver 820.

The output signal of the channel eigenvector V^{H} on the transmitter side in an embodiment may be N receive signals to be received at the receiver 820 from the wirelessly transmitted signals through M PAs and the antenna. In an embodiment, the neural network model 910 of the DPD and the valid PA 920 may be operated such that the N receive signals are equal to N input signals entered to the DPD, which are output signals from the digital precoder.

In an embodiment, based on input and output signals of the amplification unit 920 that operates in different environments, training data for training the neural network model 910 may be obtained experimentally.

The neural network model 910 trained according to an embodiment may be included in the electronic device 1000 and operated as the DPD for pre-distorting the input signal in the electronic device 1000.

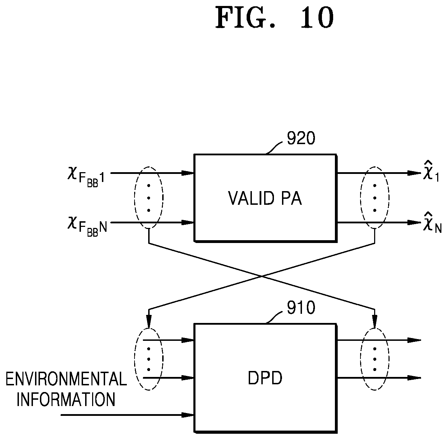

FIG. 10 illustrates an example of a method of training the neural network model 910 of the DPD in an indirect learning scheme based on the valid PA 920, according to an embodiment.

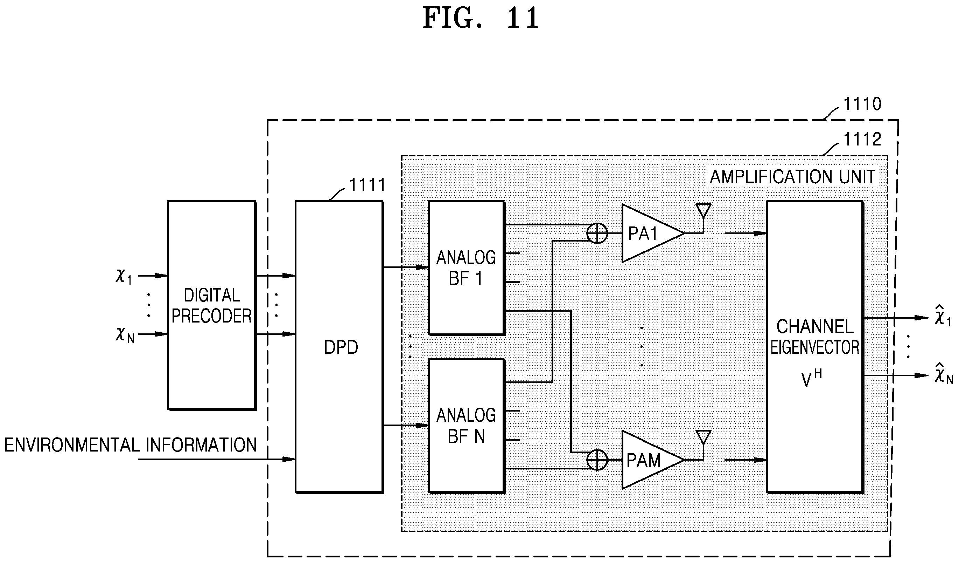

Like the fully-connected hybrid beamforming system shown in FIG. 8, when N signals pre-distorted by the pre-distorter in the electronic device 1000 are entered to the amplification unit 920 including M amplifiers, which in turn output N signals, the neural network model 910 of the DPD may be trained according to the indirect learning scheme as shown in FIG. 10 or the direct learning scheme as shown in FIG. 11.

In an embodiment, for training of the neural network model 910, hardware configuration corresponding to the amplification unit 920 may be provided.

The amplification unit 920 in an embodiment may include M PAs to process N input signals and output N output signals. The neural network model 910 of the DPD in an embodiment may be trained based on input and output signals of the amplification unit 920 defined as the virtual valid PA of FIG. 9.

The neural network model 910 of the DPD in an embodiment may be trained based on training data including a plurality of sets of N input signals entered to the amplification unit 920, which are obtained in a plurality of different environments, N output signals of the amplification unit 920 in response to the N input signals, and environmental information corresponding to the different environments.

For example, the neural network model 910 of the DPD may be trained to output signals entered to the amplification unit 920 included in the training data, i.e., signals *x F_{BB}*1 to *x F_{BB}N* output from the neural network model 910 of the DPD shown in FIG. 9, when the output signals of the amplification unit 920 included in the training data, i.e., N receive signals $\hat{{x}_{1}}$ to $\hat{{x}_{N}}$ observed as output signals of the channel eigenvector shown in FIG. 9, and environmental attributes for the plurality of PAs are entered thereto.

In an embodiment, when the amplification unit 920 is operated, a plurality of environmental attributes about temperature of the plurality of PAs included in the amplification unit 920, a magnitude and a band of the input signal may be obtained as the training data. Furthermore, in an environment corresponding to the plurality of environmental attributes obtained, based on the operation of the amplification unit 920, pairs of input signals and output signals of the amplification unit 920 may be obtained as the training data. In an embodiment, the neural network model 910 of the DPD may be trained based on training data experimentally obtained to include a plurality of environmental attributes, and pairs of the input signals and output signals of the amplification unit 920.

FIG. 11 illustrates an example of a method of training a neural network model of a DPD based on a direct learning scheme, according to another embodiment.

In the electronic device 1000 in an embodiment, when N signals pre-distorted by the DPD are entered to the amplification unit including M PAs, which in turn output N signals as in the fully-connected hybrid beamforming system, a neural network model 1111 of the DPD included in the electronic device 1000 may be trained according to the direct learning scheme of FIG. 11 without being limited to the indirect learning scheme as shown in FIG. 10.

In an embodiment, for training of the neural network model 1111, hardware configuration corresponding to the amplification unit may be provided.

In an embodiment, after the training data is obtained in a plurality of different environments, the neural network model 1111 of the DPD may be trained based on the training data. The training data in an embodiment may include a plurality of pairs of environmental information corresponding to different environments and learning models 1112 in which operations of the amplification unit corresponding to the different environments are modeled, which are obtained according to the operation of the amplification unit performed in the different environments.

A learning model in which operation of the amplification unit is modeled in an embodiment may be obtained as training data based on input and output signals of the amplification unit, which operates differently depending on the environment. For example, the learning model may be modeled such that an output signal experimentally observed in response to an arbitrary input signal of the amplification unit may be output as an output signal of the learning model.

In an embodiment, the neural network model 1111 of the DPD may be trained based on training data including a plurality of pairs of environmental information corresponding to different environments and the learning model 1112 in which operations of the amplification unit are modeled, which is obtained according to the operation of the amplification unit performed in the different environments.

The neural network model 1111 of the DPD in an embodiment may be trained such that N output signals of the modeled learning model 1112 are equal to N input signals when the N input signals and the environmental information included in the training data are processed and output by the neural network model 1111 and the modeled learning model 1112 of the training data in sequence.

The amplification unit of the learning model 1112 in an embodiment may include components including N analog BFs, M amplifiers, and a channel eigenvector. The learning model 1112 in which operations of the amplification unit are modeled in an embodiment may have different operations of the amplification unit modeled for a plurality of different environments, respectively.

For example, in an environment corresponding to a plurality of environmental attributes, signals $\hat{{x}_{1}}$ to $\hat{{x}_{N}}$ output through the amplification unit in response to various input signals may be obtained. The learning model 1112 in which operations of the amplification unit are modeled in an embodiment may be modeled to output the output signals obtained in response to the various input signals in an environment corresponding to a plurality of environmental attributes.

When the neural network model 1111 of the DPD is trained in an embodiment, data of the learning model 1112 in which the operation of the amplification unit is modeled may be fixed without modification.

According to an embodiment, as the neural network model trained in advance based on a plurality of pieces of environmental information available for the amplifier is used as a pre-distorter for the amplifier, the load of operation amount due to update of the pre-distorter according to a change in environment may be avoided.

In an embodiment, even in the fully-connected hybrid beamforming system, a neural network model trained in advance based on training data obtained in a plurality of different environments may be used as a pre-distorter.

Embodiments of the disclosure may be implemented in the form of a computer-readable recording medium that includes computer-executable instructions such as the program modules executed by the computer. The computer-readable recording medium may be an arbitrary available medium that may be accessed by the computer, including volatile, non-volatile, removable, and non-removable mediums. The computer-readable recording medium may also include a computer storage medium and a communication medium. The volatile, non-volatile, removable, and non-removable mediums may be implemented by an arbitrary method or technology for storage of information, such as computer-readable instructions, data structures, program modules, or other data. The communication medium may include computer-readable instructions, data structures, or program modules, and include arbitrary information delivery medium.

In the specification, the term "module" may refer to a hardware component such as a processor or a circuit, and/or a software component executed by the hardware component such as the processor.

Several embodiments have been described, but a person of ordinary skill in the art will understand and appreciate that various modifications can be made without departing the scope of the present disclosure. Thus, it will be apparent to those ordinary skilled in the art that the true scope of technical protection is only defined by the following claims.

While the disclosure has been shown and described with reference to certain exemplary embodiments thereof, it will be understood by those skilled in the art that various changes in form and details may be made therein without departing from the scope of the disclosure as defined by the appended claims.

## Claims

1. A method of processing an input signal of a plurality of amplifiers (620) comprised in a hybrid beamforming system, the method comprising:
obtaining an input signal for the plurality of amplifiers (620);
obtaining information about an environment of the plurality of amplifiers (620);
pre-distorting the input signal by using a pre-distorter (610) based on the obtained environmental information to prevent a plurality of output signals in response to the input signal to be processed by each of the plurality of amplifiers (620) from being distorted; and
inputting the pre-distorted input signal to each of the plurality of amplifiers (620),
wherein the pre-distorter (610) is configured to pre-distort the input signal of the plurality of amplifiers (620) by using a pretrained neural network model, wherein the pretrained neural network model is pretrained based on signals input to and output from each of the plurality of amplifiers (620) and corresponding environmental information where the plurality of amplifiers (620) operates.

2. The method of claim 1, wherein the neural network model is a model trained in advance based on training data including a plurality of sets of at least one input signal input to the plurality of amplifiers (620) obtained in a plurality of different environments, a plurality of output signals of the plurality of amplifiers (620) in response to the at least one input signal, and environmental information corresponding to the different environments, such that the at least one input signal is output from the neural network model when the plurality of output signals and the environmental information are input to the neural network model.

3. The method of claim 2, wherein, when a signal pre-distorted by the predistorter (610) is input to the plurality of amplifiers (620) and a plurality of signals are output through the plurality of amplifiers (620) comprised in the hybrid beamforming system, the neural network model is a model trained in advance based on training data including a plurality of sets, each having one input signal input to the plurality of amplifiers (620) obtained in the plurality of different environments, a representative value of a plurality of output signals of the plurality of amplifiers (620) in response to the one input signal, and environmental information corresponding to the different environments, such that the input signal is output from the neural network model when the representative value and the environmental information are input to the neural network model.

4. The method of claim 2, wherein, when N signals pre-distorted by the predistorter (610) are input to M amplifiers (620) and N signals are output through the M amplifiers (620) comprised in the hybrid beamforming system, the neural network model is a model trained in advance based on training data including a plurality of sets, each set having N input signals input to the plurality of amplifiers (620) obtained in the plurality of different environments, N output signals of the plurality of amplifiers (620) in response to the N input signals, and environmental information corresponding to the different environments, such that the N input signals are output from the neural network model when the N output signals and the environmental information are input to the neural network model.

5. The method of claim 1, wherein the neural network model is a model trained in advance based on training data including a plurality of pairs of learning models in which operations of the plurality of amplifiers (620) corresponding to different environments are modeled, which are obtained according to operations of the plurality of amplifiers (620) performed in a plurality of different environments, and environmental information corresponding to the different environments, such that at least one output signal of the modeled learning model is equal to at least one input signal when the at least one input signal and the environmental information are processed and output by the neural network model and the modeled learning model in sequence.

6. The method of claim 5, wherein, when a signal pre-distorted by the predistorter (610) is input to the plurality of amplifiers (620) and a plurality of signals are output through the plurality of amplifiers (620) comprised in the hybrid beamforming system, the neural network model is a model trained in advance based on the training data including a plurality of pairs of learning models in which operations of the plurality of amplifiers (620) are modeled, which are obtained according to operations of the plurality of amplifiers (620) performed in the plurality of different environments, and environmental information corresponding to the different environments, such that a representative value of a plurality of output signals of the modeled learning model is equal to an input signal when the input signal and the environmental information are processed and output by the neural network model and the modeled learning model in sequence.

7. The method of claim 5, wherein, when N signals pre-distorted by the predistorter (610) are input to M amplifiers (620) and N signals are output through the M amplifiers (620) comprised in the hybrid beamforming system, the neural network model is a model trained in advance based on the training data including a plurality of pairs of learning models in which operations of the plurality of amplifiers (620) are modeled, which are obtained according to operations of the plurality of amplifiers (620) performed in the plurality of different environments, and environmental information corresponding to the different environments, such that N output signals of the modeled learning model are equal to N input signals when the N input signals and the environmental information are processed and output by the neural network model and the modeled learning model in sequence.

8. A hybrid beamforming system for processing an input signal of a plurality of amplifiers (620), the hybrid beamforming system comprising:
at least one processor configured to obtain an input signal for the plurality of amplifiers (620), obtain information about an environment of the plurality of amplifiers (620), pre-distort the input signal by using a pre-distorter (610) based on the obtained environmental information to prevent a plurality of output signals in response to the input signal to be processed by each of the plurality of amplifiers (620) from being distorted, and input the pre-distorted input signal to each of the plurality of amplifiers (620); and
a communication module configured to wirelessly transmit a signal output from the plurality of amplifiers (620),
wherein the pre-distorter (610) is configured to pre-distort the input signal of the plurality of amplifiers (620) by using a pretrained neural network model, wherein the pretrained neural network model is pretrained in advance based on signals input to and output from each of the plurality of amplifiers (620) and corresponding environmental information where the plurality of amplifiers (620) operates.

9. The hybrid beamforming system of claim 8, wherein the neural network model is a model trained in advance based on training data including a plurality of sets, each set including at least one input signal input to the plurality of amplifiers (620) obtained in a plurality of different environments, a plurality of output signals of the plurality of amplifiers (620) in response to the at least one input signal, and environmental information corresponding to the different environments, such that the at least one input signal is output from the neural network model when the plurality of output signals and the environmental information are input to the neural network model.

10. The hybrid beamforming system of claim 9, wherein, when a signal pre-distorted by the pre-distorter (610) is input to the plurality of amplifiers (620) and a plurality of signals are output through the plurality of amplifiers (620) comprised in the hybrid beamforming system, the neural network model is a model trained in advance based on training data including a plurality of sets, each set including one input signal input to the plurality of amplifiers (620) obtained in the plurality of different environments, a representative value of a plurality of output signals of the plurality of amplifiers (620) in response to the one input signal, and environmental information corresponding to the different environments, such that the input signal is output from the neural network model when the representative value and the environmental information are input to the neural network model.

11. The hybrid beamforming system of claim 9, wherein, when N signals pre-distorted by the pre-distorter (610) are input to M amplifiers (620) and N signals are output through the M amplifiers (620) comprised in the hybrid beamforming system, the neural network model is a model trained in advance based on training data including a plurality of sets, each set including N input signals input to the plurality of amplifiers (620) obtained in the plurality of different environments, N output signals of the plurality of amplifiers (620) in response to the N input signals, and environmental information corresponding to the different environments, such that the N input signals are output from the neural network model when the N output signals and the environmental information are input to the neural network model.

12. The hybrid beamforming system of claim 8, wherein the neural network model is a model trained in advance based on training data including a plurality of pairs of learning models in which operations of the plurality of amplifiers (620) corresponding to different environments are modeled, which are obtained according to operations of the plurality of amplifiers (620) performed in a plurality of different environments, and environmental information corresponding to the different environments, such that at least one output signal of the modeled learning model is equal to at least one input signal when the at least one input signal and the environmental information are processed and output by the neural network model and the modeled learning model sequentially.

13. The hybrid beamforming system of claim 12, wherein, when a signal pre-distorted by the pre-distorter (610) is input to the plurality of amplifiers (620) and a plurality of signals are output through the plurality of amplifiers (620) comprised in the hybrid beamforming system, the neural network model is a model trained in advance based on the training data including a plurality of pairs of learning models in which operations of the plurality of amplifiers (620) are modeled, which are obtained according to operations of the plurality of amplifiers (620) performed in the plurality of different environments, and environmental information corresponding to the different environments, such that a representative value of a plurality of output signals of the modeled learning model is equal to an input signal when the input signal and the environmental information are processed and output by the neural network model and the modeled learning model in sequence.

14. The hybrid beamforming system of claim 12, wherein, when N signals pre-distorted by the pre-distorter (610) are input to M amplifiers (620) and N signals are output through the M amplifiers (620) comprised in the hybrid beamforming system, the neural network model is a model trained in advance based on the training data including a plurality of pairs of learning models in which operations of the plurality of amplifiers (620) are modeled, which are obtained according to operations of the plurality of amplifiers (620) performed in the plurality of different environments, and environmental information corresponding to the different environments, such that N output signals of the modeled learning model are equal to N input signals when the N input signals and the environmental information are processed and output by the neural network model and the modeled learning model in sequence.

15. A computer-readable recording medium having recorded thereon programs, when executed by a computer, cause the computer to perform the method of any of claims 1 to 7.

## Patentansprüche

1. Verfahren zum Verarbeiten eines Eingangssignals einer Mehrzahl von Verstärkern (620), die in einem hybriden Strahlenformungssystem enthalten sind, wobei das Verfahren umfasst:
Erhalten eines Eingangssignals für die Mehrzahl von Verstärkern (620);
Erhalten von Informationen über eine Umgebung der Mehrzahl von Verstärkern (620);
Vorverzerren des Eingangssignals unter Verwendung eines Vorverzerrers (610) basierend auf den erhaltenen Umgebungsinformationen, um zu verhindern, dass eine Mehrzahl von Ausgangssignalen als Reaktion auf das Eingangssignal, die von jedem der Mehrzahl von Verstärkern (620) zu verarbeiten sind, verzerrt werden; und
Eingeben des vorverzerrten Eingangssignals in jeden der Mehrzahl von Verstärkern (620),
wobei der Vorverzerrer (610) dazu konfiguriert ist, das Eingangssignal der Mehrzahl von Verstärkern (620) unter Verwendung eines vortrainierten neuronalen Netzwerkmodells vorzuverzerren, wobei das vortrainierte neuronale Netzwerkmodell basierend auf Signalen, die in jeden der Mehrzahl von Verstärkern (620) eingegeben und von diesen ausgegeben werden, und entsprechenden Umgebungsinformationen, in denen die Mehrzahl von Verstärkern (620) arbeitet, vortrainiert ist.

2. Verfahren nach Anspruch 1, wobei das neuronale Netzwerkmodell ein Modell ist, das im Voraus basierend auf Trainingsdaten trainiert wird, die eine Mehrzahl von Sätzen mindestens eines Eingangssignals, das in die Mehrzahl von Verstärkern (620) eingegeben wird und in einer Mehrzahl von verschiedenen Umgebungen erhalten wird, eine Mehrzahl von Ausgangssignalen der Mehrzahl von Verstärkern (620) als Reaktion auf das mindestens eine Eingangssignal und Umgebungsinformationen, die den verschiedenen Umgebungen entsprechen, umfassen, so dass das mindestens eine Eingangssignal von dem neuronalen Netzwerkmodell ausgegeben wird, wenn die Mehrzahl von Ausgangssignalen und die Umgebungsinformationen in das neuronale Netzwerkmodell eingegeben werden.

3. Verfahren nach Anspruch 2, wobei, wenn ein durch den Vorverzerrer (610) vorverzerrtes Signal in die Mehrzahl von Verstärkern (620) eingegeben wird und eine Mehrzahl von Signalen durch die in dem hybriden Strahlenformungssystem enthaltenen Mehrzahl von Verstärkern (620) ausgegeben wird, das neuronale Netzwerkmodell ein Modell ist, das im Voraus basierend auf Trainingsdaten trainiert wird, die eine Mehrzahl von Sätzen umfassen, wobei jeder Satz ein Eingangssignal, das in die Mehrzahl von Verstärkern (620) eingegeben wird und in der Mehrzahl von verschiedenen Umgebungen erhalten wird, einen repräsentativen Wert einer Mehrzahl von Ausgangssignalen der Mehrzahl von Verstärkern (620) als Reaktion auf das eine Eingangssignal und Umgebungsinformationen, die den verschiedenen Umgebungen entsprechen, umfasst, so dass das Eingangssignal von dem neuronalen Netzwerkmodell ausgegeben wird, wenn der repräsentative Wert und die Umgebungsinformationen in das neuronale Netzwerkmodell eingegeben werden.

4. Verfahren nach Anspruch 2, wobei, wenn durch den Vorverzerrer (610) vorverzerrte N Signale in M Verstärker (620) eingegeben werden und N Signale durch die in dem hybriden Strahlenformungssystem enthaltenen M Verstärker (620) ausgegeben werden, das neuronale Netzwerkmodell ein Modell ist, das im Voraus basierend auf Trainingsdaten trainiert wird, die eine Mehrzahl von Sätzen umfassen, wobei jeder Satz N Eingangssignale, die in die Mehrzahl von Verstärkern (620) eingegeben werden und in der Mehrzahl von verschiedenen Umgebungen erhalten werden, N Ausgangssignale der Mehrzahl von Verstärkern (620) als Reaktion auf die N Eingangssignale und Umgebungsinformationen, die den verschiedenen Umgebungen entsprechen, umfasst, so dass die N Eingangssignale von dem neuronalen Netzwerkmodell ausgegeben werden, wenn die N Ausgangssignale und die Umgebungsinformationen in das neuronale Netzwerkmodell eingegeben werden.

5. Verfahren nach Anspruch 1, wobei das neuronale Netzwerkmodell ein Modell ist, das im Voraus basierend auf Trainingsdaten trainiert wird, die eine Mehrzahl von Paaren von Lernmodellen, in denen Operationen der Mehrzahl von Verstärkern (620) entsprechend verschiedenen Umgebungen modelliert sind, welche gemäß Operationen der Mehrzahl von Verstärkern (620) erhalten werden, die in einer Mehrzahl von verschiedenen Umgebungen durchgeführt werden, und Umgebungsinformationen, die den verschiedenen Umgebungen entsprechen, umfassen, so dass mindestens ein Ausgangssignal des modellierten Lernmodells gleich mindestens einem Eingangssignal ist, wenn das mindestens eine Eingangssignal und die Umgebungsinformationen durch das neuronale Netzwerkmodell und das modellierte Lernmodell nacheinander verarbeitet und ausgegeben werden.

6. Verfahren nach Anspruch 5, wobei, wenn ein durch den Vorverzerrer (610) vorverzerrtes Signal in die Mehrzahl von Verstärkern (620) eingegeben wird und eine Mehrzahl von Signalen durch die in dem hybriden Strahlenformungssystem enthaltenen Mehrzahl von Verstärkern (620) ausgegeben wird, das neuronale Netzwerkmodell ein Modell ist, das im Voraus basierend auf den Trainingsdaten trainiert wird, die eine Mehrzahl von Paaren von Lernmodellen, in denen Operationen der Mehrzahl von Verstärkern (620) modelliert sind, welche gemäß Operationen der Mehrzahl von Verstärkern (620) erhalten werden, die in der Mehrzahl von verschiedenen Umgebungen durchgeführt werden, und Umgebungsinformationen, die den verschiedenen Umgebungen entsprechen, umfassen, so dass ein repräsentativer Wert einer Mehrzahl von Ausgangssignalen des modellierten Lernmodells gleich einem Eingangssignal ist, wenn das Eingangssignal und die Umgebungsinformationen durch das neuronale Netzwerkmodell und das modellierte Lernmodell nacheinander verarbeitet und ausgegeben werden.

7. Verfahren nach Anspruch 5, wobei, wenn durch den Vorverzerrer (610) vorverzerrte N Signale in M Verstärker (620) eingegeben werden und N Signale durch die in dem Hybrid-Strahlenformungssystem enthaltenen M Verstärker (620) ausgegeben werden, das neuronale Netzwerkmodell ein Modell ist, das im Voraus basierend auf den Trainingsdaten trainiert wird, die eine Mehrzahl von Paaren von Lernmodellen, in denen Operationen der Mehrzahl von Verstärkern (620) modelliert sind, welche gemäß Operationen der Mehrzahl von Verstärkern (620) erhalten werden, die in der Mehrzahl von verschiedenen Umgebungen durchgeführt werden, und Umgebungsinformationen, die den verschiedenen Umgebungen entsprechen, umfassen, so dass N Ausgangssignale des modellierten Lernmodells gleich N Eingangssignalen sind, wenn die N Eingangssignale und die Umgebungsinformationen durch das neuronale Netzwerkmodell und das modellierte Lernmodell nacheinander verarbeitet und ausgegeben werden.

8. Hybrides Strahlenformungssystem zum Verarbeiten eines Eingangssignals einer Mehrzahl von Verstärkern (620), wobei das hybride Strahlenformungssystem umfasst:
mindestens einen Prozessor, der dazu konfiguriert ist, ein Eingangssignal für die Mehrzahl von Verstärkern (620) zu erhalten, Informationen über eine Umgebung der Mehrzahl von Verstärkern (620) zu erhalten, das Eingangssignal unter Verwendung eines Vorverzerrers (610) basierend auf den erhaltenen Umgebungsinformationen vorzuverzerren, um zu verhindern, dass eine Mehrzahl von Ausgangssignalen als Reaktion auf das Eingangssignal, die von jedem der Mehrzahl von Verstärkern (620) zu verarbeiten sind, verzerrt werden, und das vorverzerrte Eingangssignal in jeden der Mehrzahl von Verstärkern (620) einzugeben; und
ein Kommunikationsmodul, das dazu konfiguriert ist, ein von der Mehrzahl von Verstärkern (620) ausgegebenes Signal drahtlos zu senden,
wobei der Vorverzerrer (610) dazu konfiguriert ist, das Eingangssignal der Mehrzahl von Verstärkern (620) unter Verwendung eines vortrainierten neuronalen Netzwerkmodells vorzuverzerren, wobei das vortrainierte neuronale Netzwerkmodell im Voraus basierend auf Signalen, die in jeden der Mehrzahl von Verstärkern (620) eingegeben und von diesen ausgegeben werden, und entsprechenden Umgebungsinformationen, in denen die Mehrzahl von Verstärkern (620) arbeitet, vortrainiert ist.

9. Hybrides Strahlenformungssystem nach Anspruch 8, wobei das neuronale Netzwerkmodell ein Modell ist, das im Voraus basierend auf Trainingsdaten trainiert wird, die eine Mehrzahl von Sätzen umfassen, wobei jeder Satz mindestens ein Eingangssignal, das in die Mehrzahl von Verstärkern (620) eingegeben wird und in einer Mehrzahl von verschiedenen Umgebungen erhalten wird, eine Mehrzahl von Ausgangssignalen der Mehrzahl von Verstärkern (620) als Reaktion auf das mindestens eine Eingangssignal und Umgebungsinformationen, die den verschiedenen Umgebungen entsprechen, umfasst, so dass das mindestens eine Eingangssignal von dem neuronalen Netzwerkmodell ausgegeben wird, wenn die Mehrzahl von Ausgangssignalen und die Umgebungsinformationen in das neuronale Netzwerkmodell eingegeben werden.

10. Hybrides Strahlenformungssystem nach Anspruch 9, wobei, wenn ein durch den Vorverzerrer (610) vorverzerrtes Signal in die Mehrzahl von Verstärkern (620) eingegeben wird und eine Mehrzahl von Signalen durch die in dem hybriden Strahlenformungssystem enthaltenen Mehrzahl von Verstärkern (620) ausgegeben wird, das neuronale Netzwerkmodell ein Modell ist, das im Voraus basierend auf Trainingsdaten trainiert wird, die eine Mehrzahl von Sätzen umfassen, wobei jeder Satz ein Eingangssignal, das in die Mehrzahl von Verstärkern (620) eingegeben wird und in der Mehrzahl von verschiedenen Umgebungen erhalten wird, einen repräsentativen Wert einer Mehrzahl von Ausgangssignalen der Mehrzahl von Verstärkern (620) als Reaktion auf das eine Eingangssignal und Umgebungsinformationen, die den verschiedenen Umgebungen entsprechen, umfasst, so dass das Eingangssignal von dem neuronalen Netzwerkmodell ausgegeben wird, wenn der repräsentative Wert und die Umgebungsinformationen in das neuronale Netzwerkmodell eingegeben werden.

11. Hybrides Strahlenformungssystem nach Anspruch 9, wobei, wenn durch den Vorverzerrer (610) vorverzerrte N Signale in M Verstärker (620) eingegeben werden und N Signale durch die in dem hybriden Strahlenformungssystem enthaltenen M Verstärker (620) ausgegeben werden, das neuronale Netzwerkmodell ein Modell ist, das im Voraus basierend auf Trainingsdaten trainiert wird, die eine Mehrzahl von Sätzen umfassen, wobei jeder Satz N Eingangssignale, die in die Mehrzahl von Verstärkern (620) eingegeben werden und in der Mehrzahl von verschiedenen Umgebungen erhalten werden, N Ausgangssignale der Mehrzahl von Verstärkern (620) als Reaktion auf die N Eingangssignale und Umgebungsinformationen, die den verschiedenen Umgebungen entsprechen, umfasst, so dass die N Eingangssignale von dem neuronalen Netzwerkmodell ausgegeben werden, wenn die N Ausgangssignale und die Umgebungsinformationen in das neuronale Netzwerkmodell eingegeben werden.

12. Hybrides Strahlenformungssystem nach Anspruch 8, wobei das neuronale Netzwerkmodell ein Modell ist, das im Voraus basierend auf Trainingsdaten trainiert wird, die eine Mehrzahl von Paaren von Lernmodellen, in denen Operationen der Mehrzahl von Verstärkern (620) entsprechend verschiedenen Umgebungen modelliert sind, welche gemäß Operationen der Mehrzahl von Verstärkern (620) erhalten werden, die in einer Mehrzahl von verschiedenen Umgebungen durchgeführt werden, und Umgebungsinformationen, die den verschiedenen Umgebungen entsprechen, umfassen, so dass mindestens ein Ausgangssignal des modellierten Lernmodells gleich mindestens einem Eingangssignal ist, wenn das mindestens eine Eingangssignal und die Umgebungsinformationen durch das neuronale Netzwerkmodell und das modellierte Lernmodell nacheinander verarbeitet und ausgegeben werden.

13. Hybrides Strahlenformungssystem nach Anspruch 12, wobei, wenn ein durch den Vorverzerrer (610) vorverzerrtes Signal in die Mehrzahl von Verstärkern (620) eingegeben wird und eine Mehrzahl von Signalen durch die in dem hybriden Strahlenformungssystem enthaltenen Mehrzahl von Verstärkern (620) ausgegeben wird, das neuronale Netzwerkmodell ein Modell ist, das im Voraus basierend auf den Trainingsdaten trainiert wird, die eine Mehrzahl von Paaren von Lernmodellen, in denen Operationen der Mehrzahl von Verstärkern (620) modelliert sind, welche gemäß Operationen der Mehrzahl von Verstärkern (620) erhalten werden, die in der Mehrzahl von verschiedenen Umgebungen durchgeführt werden, und Umgebungsinformationen, die den verschiedenen Umgebungen entsprechen, umfassen, so dass ein repräsentativer Wert einer Mehrzahl von Ausgangssignalen des modellierten Lernmodells gleich einem Eingangssignal ist, wenn das Eingangssignal und die Umgebungsinformationen durch das neuronale Netzwerkmodell und das modellierte Lernmodell nacheinander verarbeitet und ausgegeben werden.

14. Hybrides Strahlenformungssystem nach Anspruch 12, wobei, wenn N durch den Vorverzerrer (610) vorverzerrte Signale in M Verstärker (620) eingegeben werden und N Signale durch die in dem hybriden Strahlenformungssystem enthaltenen M Verstärker (620) ausgegeben werden, das neuronale Netzwerkmodell ein Modell ist, das im Voraus basierend auf den Trainingsdaten trainiert wird, die eine Mehrzahl von Paaren von Lernmodellen, in denen Operationen der Mehrzahl von Verstärkern (620) modelliert sind, welche gemäß Operationen der Mehrzahl von Verstärkern (620) erhalten werden, die in der Mehrzahl von verschiedenen Umgebungen durchgeführt werden, und Umgebungsinformationen, die den verschiedenen Umgebungen entsprechen, umfassen, so dass N Ausgangssignale des modellierten Lernmodells gleich N Eingangssignalen sind, wenn die N Eingangssignale und die Umgebungsinformationen durch das neuronale Netzwerkmodell und das modellierte Lernmodell nacheinander verarbeitet und ausgegeben werden.

15. Computerlesbares Aufzeichnungsmedium, auf dem Programme aufgezeichnet sind, die, wenn sie von einem Computer ausgeführt werden, den Computer veranlassen, das Verfahren nach einem der Ansprüche 1 bis 7 durchzuführen.

## Revendications

1. Procédé de traitement d'un signal d'entrée d'une pluralité d'amplificateurs (620) compris dans un système de formation de faisceaux hybride, le procédé comprenant :
obtenir un signal d'entrée pour la pluralité d'amplificateurs (620) ;
obtenir des informations concernant un environnement de la pluralité d'amplificateurs (620) ;
pré-distordre le signal d'entrée en utilisant un pré-distordeur (610) sur la base des informations environnementales obtenues, afin d'empêcher qu'une pluralité de signaux de sortie en réponse au signal d'entrée traité par chacun de la pluralité d'amplificateurs (620) ne soient distordus ; et
appliquer le signal d'entrée pré-distordu à chacun de la pluralité d'amplificateurs (620),
dans lequel le pré-distordeur (610) est configuré pour pré-distordre le signal d'entrée de la pluralité d'amplificateurs (620) en utilisant un modèle de réseau neuronal pré-entraîné, dans lequel le modèle de réseau neuronal pré-entraîné est pré-entraîné sur la base des signaux appliqués en entrée et délivrés en sortie par chacun de la pluralité d'amplificateurs (620) et des informations environnementales correspondantes dans lesquelles la pluralité d'amplificateurs (620) fonctionne.

2. Procédé selon la revendication 1, dans lequel le modèle de réseau neuronal est un modèle entraîné à l'avance sur la base des données d'entraînement comprenant une pluralité d'ensembles d'au moins un signal d'entrée appliqué à la pluralité d'amplificateurs (620) obtenus dans une pluralité d'environnements différents, une pluralité de signaux de sortie de la pluralité d'amplificateurs (620) en réponse audit au moins un signal d'entrée, et des informations environnementales correspondant aux environnements différents, de sorte que ledit au moins un signal d'entrée soit délivré en sortie par le modèle de réseau neuronal lorsque la pluralité de signaux de sortie et les informations environnementales sont appliqués en entrée au modèle de réseau neuronal.

3. Procédé selon la revendication 2, dans lequel, lorsqu'un signal pré-distordu par le pré-distordeur (610) est appliqué à la pluralité d'amplificateurs (620) et qu'une pluralité de signaux sont délivrés en sortie par la pluralité d'amplificateurs (620) compris dans le système de formation de faisceaux hybride, le modèle de réseau neuronal est un modèle entraîné à l'avance sur la base des données d'entraînement comprenant une pluralité d'ensembles, chacun comportant un signal d'entrée appliqué à la pluralité d'amplificateurs (620) obtenu dans la pluralité d'environnements différents, une valeur représentative d'une pluralité de signaux de sortie de la pluralité d'amplificateurs (620) en réponse audit signal d'entrée, et des informations environnementales correspondant aux environnements différents, de sorte que le signal d'entrée soit délivré en sortie par le modèle de réseau neuronal lorsque la valeur représentative et les informations environnementales sont appliqués en entrée au modèle de réseau neuronal.

4. Procédé selon la revendication 2, dans lequel, lorsque N signaux pré-distordus par le pré-distordeur (610) sont appliqués en entrée aux M amplificateurs (620) et que N signaux sont délivrés par les M amplificateurs (620) compris dans le système de formation de faisceaux hybride, le modèle de réseau neuronal est un modèle entraîné à l'avance sur la base des données d'entraînement comprenant une pluralité d'ensembles, chaque ensemble comportant N signaux d'entrée appliqués à la pluralité d'amplificateurs (620) obtenus dans la pluralité d'environnements différents, N signaux de sortie de la pluralité d'amplificateurs (620) en réponse aux N signaux d'entrée, et des informations environnementales correspondant aux environnements différents, de sorte que les N signaux d'entrée soient délivrés en sortie par le modèle de réseau neuronal lorsque les N signaux de sortie et les informations environnementales sont appliquées en entrée au modèle de réseau neuronal.

5. Procédé selon la revendication 1, dans lequel le modèle de réseau neuronal est un modèle entraîné à l'avance sur la base des données d'entraînement comprenant une pluralité de paires de modèles d'apprentissage dans lesquels des opérations de la pluralité d'amplificateurs (620) correspondant aux environnements différents sont modélisées, lesquelles sont obtenues selon les opérations de la pluralité d'amplificateurs (620) effectuées dans une pluralité d'environnements différents, et des informations environnementales correspondant aux environnements différents, de sorte qu'au moins un signal de sortie du modèle d'apprentissage modélisé soit égal à au moins un signal d'entrée lorsque ledit au moins un signal d'entrée et les informations environnementales sont traités et délivrés en sortie par le modèle de réseau neuronal et le modèle d'apprentissage modélisé en séquence.

6. Procédé selon la revendication 5, dans lequel, lorsqu'un signal pré-distordu par le pré-distordeur (610) est appliqué en entrée à la pluralité d'amplificateurs (620) et qu'une pluralité de signaux sont délivrés en sortie par la pluralité d'amplificateurs (620) compris dans le système de formation de faisceaux hybride, le modèle de réseau neuronal est un modèle entraîné à l'avance sur la base des données d'entraînement comprenant une pluralité de paires de modèles d'apprentissage dans lesquels des opérations de la pluralité d'amplificateurs (620) sont modélisées, lesquelles sont obtenues selon les opérations de la pluralité d'amplificateurs (620) effectuées dans la pluralité d'environnements différents, et des informations environnementales correspondant aux environnements différents, de sorte qu'une valeur représentative d'une pluralité de signaux de sortie du modèle d'apprentissage modélisé soit égale à un signal d'entrée lorsque le signal d'entrée et les informations environnementales sont traités et délivrés en sortie par le modèle de réseau neuronal et le modèle d'apprentissage modélisé en séquence.

7. Procédé selon la revendication 5, dans lequel, lorsque N signaux pré-distordus par le pré-distordeur (610) sont appliqués en entrée à M amplificateurs (620) et que N signaux sont délivrés en sortie par les M amplificateurs (620) compris dans le système de formation de faisceaux hybride, le modèle de réseau neuronal est un modèle entraîné à l'avance sur la base des données d'entraînement comprenant une pluralité de paires de modèles d'apprentissage dans lesquels des opérations de la pluralité d'amplificateurs (620) sont modélisées, lesquelles sont obtenues selon les opérations de la pluralité d'amplificateurs (620) effectuées dans la pluralité d'environnements différents, et des informations environnementales correspondant aux différents environnements, de sorte que N signaux de sortie du modèle d'apprentissage modélisé soient égaux à N signaux d'entrée lorsque les N signaux d'entrée et les informations environnementales sont traités et délivrés en sortie par le modèle de réseau neuronal et le modèle d'apprentissage modélisé en séquence.

8. Système de formation de faisceaux hybride pour traiter un signal d'entrée d'une pluralité d'amplificateurs (620), le système de formation de faisceaux hybride comprenant :
au moins un processeur configuré pour obtenir un signal d'entrée pour la pluralité d'amplificateurs (620), obtenir des informations concernant un environnement de la pluralité d'amplificateurs (620), pré-distordre le signal d'entrée en utilisant un pré-distordeur (610) sur la base des informations environnementales obtenues afin d'empêcher qu'une pluralité de signaux de sortie en réponse au signal d'entrée devant être traité par chacun de la pluralité d'amplificateurs (620) ne soient distordus, et appliquer le signal d'entrée pré-distordu à chacun de la pluralité d'amplificateurs (620) ; et
un module de communication configuré pour transmettre sans fil un signal délivré en sortie par la pluralité d'amplificateurs (620),
dans lequel le pré-distordeur (610) est configuré pour pré-distordre le signal d'entrée de la pluralité d'amplificateurs (620) en utilisant un modèle de réseau neuronal pré-entraîné, dans lequel le modèle de réseau neuronal pré-entraîné est pré-entraîné à l'avance sur la base des signaux appliqués en entrée et délivrés en sortie par chacun de la pluralité d'amplificateurs (620) et des informations environnementales correspondantes dans lesquelles la pluralité d'amplificateurs (620) fonctionne.

9. Système de formation de faisceaux hybride selon la revendication 8, dans lequel le modèle de réseau neuronal est un modèle entraîné à l'avance sur la base des données d'entraînement comprenant une pluralité d'ensembles, chaque ensemble comprenant au moins un signal d'entrée appliqué à la pluralité d'amplificateurs (620) obtenu dans une pluralité d'environnements différents, une pluralité de signaux de sortie de la pluralité d'amplificateurs (620) en réponse audit au moins un signal d'entrée, et des informations environnementales correspondant aux environnements différents, de sorte que ledit au moins un signal d'entrée soit délivré en sortie par le modèle de réseau neuronal lorsque la pluralité de signaux de sortie et les informations environnementales sont appliquées en entrée au modèle de réseau neuronal.

10. Système de formation de faisceaux hybride selon la revendication 9, dans lequel, lorsqu'un signal pré-distordu par le pré-distordeur (610) est appliqué en entrée à la pluralité d'amplificateurs (620) et qu'une pluralité de signaux sont délivrés en sortie par la pluralité d'amplificateurs (620) compris dans le système de formation de faisceaux hybride, le modèle de réseau neuronal est un modèle entraîné à l'avance sur la base des données d'entraînement comprenant une pluralité d'ensembles, chaque ensemble comprenant un signal d'entrée appliqué à la pluralité d'amplificateurs (620) obtenu dans la pluralité d'environnements différents, une valeur représentative d'une pluralité de signaux de sortie de la pluralité d'amplificateurs (620) en réponse audit signal d'entrée, et des informations environnementales correspondant aux environnements différents, de sorte que le signal d'entrée soit délivré en sortie par le modèle de réseau neuronal lorsque la valeur représentative et les informations environnementales sont appliquées en entrée au modèle de réseau neuronal.

11. Système de formation de faisceaux hybride selon la revendication 9, dans lequel, lorsque N signaux pré-distordus par le pré-distordeur (610) sont appliqués en entrée à M amplificateurs (620) et que N signaux sont délivrés en sortie par les M amplificateurs (620) compris dans le système de formation de faisceaux hybride, le modèle de réseau neuronal est un modèle entraîné à l'avance sur la base des données d'entraînement comprenant une pluralité d'ensembles, chaque ensemble comprenant N signaux d'entrée appliqués à la pluralité d'amplificateurs (620) obtenus dans la pluralité d'environnements différents, N signaux de sortie de la pluralité d'amplificateurs (620) en réponse aux N signaux d'entrée, et des informations environnementales correspondant aux environnements différents, de sorte que les N signaux d'entrée soient délivrés en sortie par le modèle de réseau neuronal lorsque les N signaux de sortie et les informations environnementales sont appliqués en entrée au modèle de réseau neuronal.

12. Système de formation de faisceaux hybride selon la revendication 8, dans lequel le modèle de réseau neuronal est un modèle entraîné à l'avance sur la base des données d'entraînement comprenant une pluralité de paires de modèles d'apprentissage dans lesquels des opérations de la pluralité d'amplificateurs (620) correspondant aux environnements différents sont modélisées, lesquelles sont obtenues selon les opérations de la pluralité d'amplificateurs (620) effectuées dans une pluralité d'environnements différents, et des informations environnementales correspondant aux environnements différents, de sorte qu'au moins un signal de sortie du modèle d'apprentissage modélisé soit égal à au moins un signal d'entrée lorsque ledit au moins un signal d'entrée et les informations environnementales sont traités et délivrés en sortie par le modèle de réseau neuronal et le modèle d'apprentissage modélisé en séquence.

13. Système de formation de faisceaux hybride selon la revendication 12, dans lequel, lorsqu'un signal pré-distordu par le pré-distordeur (610) est appliqué en entrée à la pluralité d'amplificateurs (620) et qu'une pluralité de signaux sont délivrés en sortie par la pluralité d'amplificateurs (620) compris dans le système de formation de faisceaux hybride, le modèle de réseau neuronal est un modèle entraîné à l'avance sur la base des données d'entraînement comprenant une pluralité de paires de modèles d'apprentissage dans lesquels des opérations de la pluralité d'amplificateurs (620) sont modélisées, lesquelles sont obtenues selon les opérations de la pluralité d'amplificateurs (620) effectuées dans la pluralité d'environnements différents, et des informations environnementales correspondant aux environnements différents, de sorte qu'une valeur représentative d'une pluralité de signaux de sortie du modèle d'apprentissage modélisé soit égale à un signal d'entrée lorsque le signal d'entrée et les informations environnementales sont traités et délivrés en sortie par le modèle de réseau neuronal et le modèle d'apprentissage modélisé en séquence.

14. Système de formation de faisceaux hybride selon la revendication 12, dans lequel, lorsque N signaux pré-distordus par le pré-distordeur (610) sont appliqués en entrée à M amplificateurs (620) et que N signaux sont délivrés en sortie par les M amplificateurs (620) compris dans le système de formation de faisceaux hybride, le modèle de réseau neuronal est un modèle entraîné à l'avance sur la base des données d'entraînement comprenant une pluralité de paires de modèles d'apprentissage dans lesquels des opérations de la pluralité d'amplificateurs (620) sont modélisées, lesquelles sont obtenues selon les opérations de la pluralité d'amplificateurs (620) effectuées dans la pluralité d'environnements différents, et des informations environnementales correspondant aux environnements différents, de sorte que N signaux de sortie du modèle d'apprentissage modélisé soient égaux à N signaux d'entrée lorsque les N signaux d'entrée et les informations environnementales sont traités et délivrés en sortie par le modèle de réseau neuronal et le modèle d'apprentissage modélisé en séquence.

15. Support d'enregistrement lisible par ordinateur sur lequel sont enregistrés des programmes qui, lorsqu'ils sont exécutés par un ordinateur, amènent l'ordinateur à mettre en œuvre le procédé selon l'une quelconque des revendications 1 à 7.
